# DEMANDE DE BREVET EUROPEEN

(11) **EP 0 677 924 A1**
(43) Date de publication de la demande: **18.10.1995**
(21) Numéro de dépôt: 95400807.4
(22) Date de dépôt: 11.04.1995
(51) Int. Cl.: H03K 5/13

(54) **Circuit à retard réglable**

(30) Priorité: 13.04.1994 FR 9404331
(71) Demandeur: BULL S.A., F-78430 Louveciennes (FR)
(72) Inventeur: Bedouani, Mohamed, F-78220 Viroflay (FR)
(74) Mandataire: Denis, Hervé

(57) **Abrégé**

L'invention a pour objet un circuit à retard intégré (10) comprenant deux amplificateurs (11a, 11b) fournissant des retards différents et ayant une entrée commune, et des moyens de commande (12) connectés à deux bornes respectives des deux amplificateurs pour faire varier le déphasage entre les deux amplificateurs. Ce circuit s'applique notamment à l'intégration dans un semi-conducteur III-V tel que l'arséniure de gallium.

## Description

### Domaine technique

L'invention se rapporte à un circuit à retard intégré, plus particulièrement adapté aux très hauts débits, par exemple supérieurs à 1 gigabit par seconde, et convenant plus particulièrement à une intégration dans un semi-conducteur III-V tel que l'arséniure de gallium (GaAs). Dans cette application, le circuit à retard peut être fait de transistors à effet de champ, surtout ceux de type MESFET (Metal-Semiconductor Field-Effect Transistor) et convient alors plus particulièrement à la logique de type DCFL (Direct-Coupled FET Logic) incluant la logique BDCFL (Buffered DCFL). Il peut aussi être fait de transistors à effet de champ de type HEMT (High-Electron-Mobility Transistor) intégrés dans un matériau semi-conducteur ternaire tel que l'arséniure de gallium et d'aluminium du type AlGaAs / GaAs par exemple. On verra aussi que l'invention s'applique aussi aux amplificateurs différentiels, à transistors bipolaires mais plus avantageusement à transistors de type MESFET en logique SCFL (Source-Coupled FET Logic. Le circuit à retard conforme à l'invention peut facilement être réglable linéairement et s'applique plus particulièrement aux systèmes de transmission à très haut débit et aux systèmes informatiques employant aussi des transmissions à très haut débit.

### L'art antérieur

Les circuits à retard comprenant un amplificateur dont une borne est connectée à un bloc de commande de la variation du retard par réglage du courant fourni par l'amplificateur sont bien connus et utilisés. Leurs blocs de commande sont couramment faits de circuits RC, et le réglage du retard se fait par variation de la valeur de la résistance et/ou de la capacité des circuits RC. Dans un circuit intégré à transistors à effet de champ, par exemple de type MOS (Métal Oxyde Semi-conducteur), la résistance et la capacité sont ordinairement constituées par des transistors.

L'inconvénient de tels circuits à retard est la courbe de forme exponentielle de la variation du retard par rapport à la variation des valeurs de R et de C. La linéarité du réglage du retard nécessite donc des produits RC de fortes valeurs, incompatibles avec des temps de retard très courts. D'autre part, les circuits RC doivent être insérés entre des circuits tampons d'entrée et de sortie pour rendre le circuits extérieurs insensibles aux variations de R et de C. En outre, la technologie de fabrication des transistors à effet de champ produit de fortes dérives dans les caractéristiques des transistors de circuits intégrés différents. Ces dérives s'opposent à la fiabilité et à la finesse recherchées du réglage du courant.

L'emploi de retards réglables très courts s'impose actuellement dans certains cas, tels que dans le circuit verrouillé en phase de très haute fréquence décrit dans le document EP-0441684 et le système de transmission numérique à haut débit décrit dans les documents EP-A-0466591, EP-A-0466592 et EP-A-0466593. A titre indicatif, ce circuit et ce système peuvent nécessiter des retards réglables par pas de quelques picosecondes seulement. De plus, la linéarité de la variation de ces retards est une condition qui facilite la commande et améliore considérablement ses performances. En outre, il faut que ces circuits à retard soient très compacts et adaptables aux technologies rapides, telles que celles faites de transistors à effet de champ et plus particulièrement celles intégrées dans un semi-conducteur III-V. Dans cette dernière application, la logique DCFL offre l'avantage de faire des portes logiques très simples et très rapides, faites seulement de deux transistors montés en série entre les potentiels d'alimentation, et d'avoir une faible consommation énergétique sous une basse tension d'alimentation, ordinairement de deux volts. Elle a par contre l'inconvénient de présenter des temps de commutation dissymétriques, le temps de montée différant notablement du temps de descente. La logique BDCFL supprime cet inconvénient au prix seulement de rajouter deux autres transistors en série entre les potentiels d'alimentation. Ces deux logiques seront dites de type DCFL.

On connaît des circuits à retard faits de transistors de types complémentaires, tels que les circuits à retard du type CMOS (Complementary MOS). Cependant, ils ne sont pas transposables en logique de type DCFL, puisqu'elle n'est pas une logique faite de transistors complémentaires. D'autre part, le demandeur a déjà décrit dans ses demandes de brevet européen EP-A-0493149 et EP-A-0493150 des circuits à retard faits d'amplificateurs différentiels permettant d'obtenir des retards sensiblement linéaires. Ces dispositifs à retard conviennent bien à la technologie bipolaire en logique ECL (Emitter-Coupled Logic) ou CML (Current-Mode Logic) intégrée dans le silicium monocristallin. Cependant, ces circuits ne sont pas transposables en logique de type DCFL, puisqu'elle n'a pas une structure différentielle.

### L'invention

L'invention présente une solution permettant d'avoir un circuit à retard réglable avec une bonne linéarité, capable de fournir des retards très courts par pas très fins, adaptable à l'intégration dans un semi-conducteur III-V et convenant plus particulièrement à la logique de type DCFL, pouvant avoir une structure très compacte et fiable, et apte à fournir des retards s'étendant dans une gamme très large.

L'invention a pour objet un circuit à retard intégré, caractérisé en ce qu'il comprend deux amplificateurs fournissant des retards différents et ayant une entrée commune, et des moyens de commande connectés à deux bornes respectives des deux amplificateurs pour faire varier le déphasage entre les deux amplificateurs.

L'invention ressort de la description détaillée qui suit, donnée à titre d'exemple et faite en référence aux dessins annexés. Dans les dessins:
- la figure 1 illustre schématiquement la structure conforme à l'invention d'un circuit à retard réglable linéairement et fait en logique mixte DCFL / BDCFL;
- la figure 2 est un graphe illustrant la variation du retard obtenu du circuit à retard représenté sur la figure 1;
- la figure 3 illustre schématiquement une variante conforme à l'invention d'un circuit à retard réglable linéairement et fait en logique DCFL;
- la figure 4 illustre un graphe illustrant la variation du retard obtenu du circuit représenté sur la figure 3;
- la figure 5 illustre une autre variante conforme à l'invention d'un circuit à retard réglable linéairement et fait en logique BDCFL; et
- la figure 6 illustre encore une autre variante conforme à l'invention d'un circuit à retard réglable linéairement et ayant une structure différentielle.

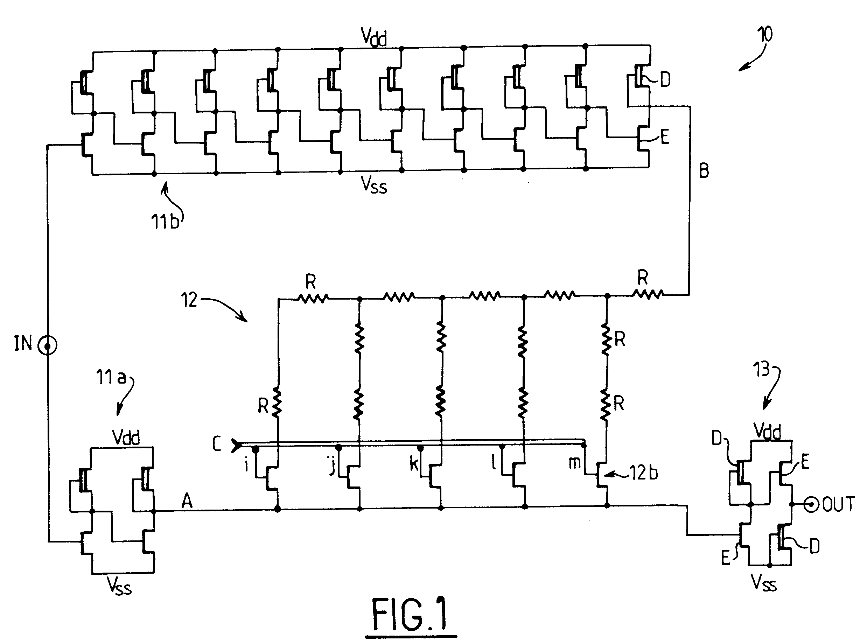

La figure 1 présente un premier exemple de réalisation d'un circuit à retard 10 faits de transistors MESFET en logique mixte DCFL et BDCFL. Le circuit à retard 10 illustré comprend deux amplificateurs 11a et 11b, un bloc de commande de retard 12, et un tampon de sortie 13. Les deux amplificateurs 11a et 11b ont une entrée commune recevant le signal d'entrée IN du circuit 10 et deux sorties respectives A et B. Les amplificateurs 11a et 11b sont faits chacun d'au moins un inverseur DCFL. Un inverseur DCFL est composé d'un transistor de commande E à enrichissement et d'un transistor à déplétion D ayant sa source connectée à sa grille pour fonctionner comme une résistance de charge. Les trajets drain-source des deux transistors D et E sont connectés en série entre deux potentiels d'alimentation Vdd et Vss. Dans l'exemple illustré, Vdd représente la masse et Vss = -2 volts, l'amplificateur 11a est fait de deux inverseurs successifs DCFL et l'amplificateur 11b de dix inverseurs DCFL en cascade. Le transistor de commande E reçoit sur sa grille le signal d'entrée de l'inverseur et fournit sur son drain le signal de sortie. A titre indicatif, le dimensionnement des transistors D et E a été effectué de la manière suivante. En appelant W et L la largeur et la longueur électrique d'un transistor et en leur attribuant comme indice le nom du transistor correspondant, le rapport β = (W_{E}/L_{E}) / (W_{D}/L_{D}) était de l'ordre de 10.

Le bloc de commande numérique de retard 12 de l'exemple illustré est fait d'un réseau résistif itératif R-2R (resistive ladder network) comprenant de manière classique des étages R-2R connectés à des interrupteurs respectifs actionnés par un signal de commande. Plus précisément, les étages R-2R du réseau 12 sont connectés aux sorties respectives A et B des amplificateurs 11a et 11b et à des interrupteurs respectifs 12b commandés sélectivement par le signal de commande numérique C. Les interrupteurs 12b sont faits de transistors à effet de champ à enrichissement, dont les grilles de commande reçoivent le signal de commande numérique C et dont les sources sont interconnectées en commun à la sortie à la sortie A de l'amplificateur 11a. Le dernier étage R-2R a la résistance R connectée à la sortie B de l'amplificateur 11b, tandis que le premier étage est seulement un étage R-R pour les raisons indiquées ultérieurement. Afin d'obtenir un réglage numérique de 32 pas du retard global du circuit 10, le réseau 12 comprend cinq étages R-2R et le signal de commande C se compose de cinq bits de commande répartis en cinq i, j, k, I, m appliqués aux grilles respectives des transistors 12b. Chaque transistor interrupteur est rendu passant par la mise au potentiel haut Vdd de sa grille. Les transistors interrupteurs 12b sont dimensionnés de façon que les courants qui traversent les étages R-2R successifs du réseau 12 soient sensiblement égaux à l/2, l/4, l/8, l/16 et l/32. Ces valeurs sont obtenues en donnant aux transistors interrupteurs des largeurs électriques respectives 5W, 4W, 3W, 2W et W, puisque la résistance série d'un transistor MESFET est inversement proportionnelle à la largeur de la grille.

Le tampon de sortie 13 est fait d'au moins un inverseur BDCFL, un seul dans l'exemple illustré. Un inverseur BDCFL est fait d'une couche d'entrée ayant la structure d'un inverseur DCFL et d'une couche de sortie faite du montage série d'un transistor à enrichissement E de commande ayant son. drain connecté au potentiel d'alimentation Vdd et sa grille connectée au drain du transistor de commande E de la couche d'entrée, et d'un transistor à déplétion D servant de charge résistive, dont la source est connectée à la grille et au potentiel d'alimentation Vss et dont le drain fournit le signal de sortie OUT. En pratique, pour des raisons d'adaptation d'impédance, le rapport β des transistors de la couche de sortie est de l'ordre de l'unité. Dans l'exemple illustré, les transistors de la couche d'entrée avait un rapport β = 5. La grille du transistor de commande E de la couche d'entrée est connectée directement aux bornes communes des interrupteurs 12b et à la borne de sortie A du réseau 12.

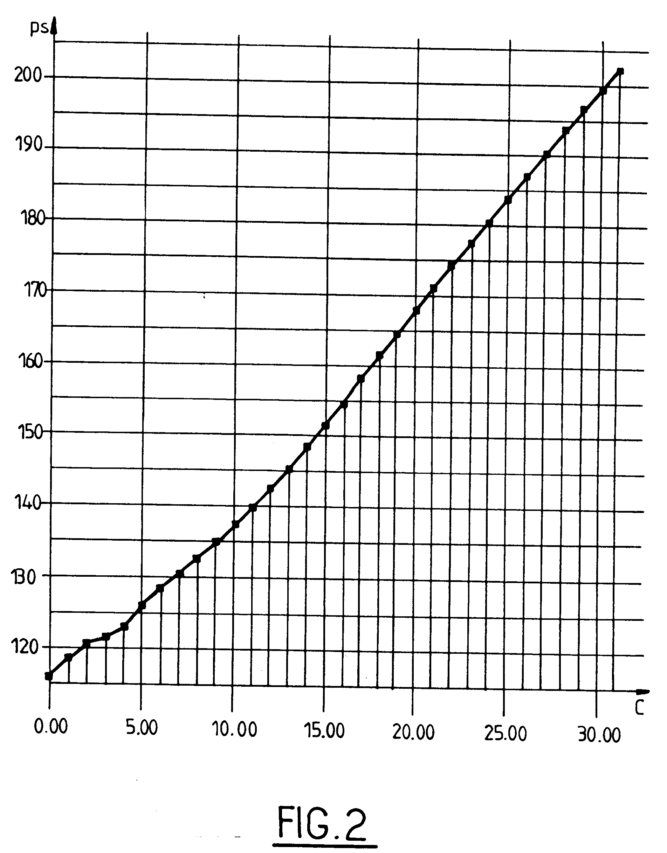

Le fonctionnement du circuit à retard 10 va être décrit en référence au graphe de la figure 2 illustrant les retards successifs obtenus entre le signal d'entrée IN et le signal de sortie OUT par une variation progressive du signal de commande C de 32 pas. Lorsque les bits i-m sont au niveau bas et ont la valeur logique 0, tous les interrupteurs 12b sont ouverts et isolent ainsi l'amplificateur 11b et le réseau 12 du tampon de sortie 13. Le signal **IN** ne traverse donc que l'amplificateur11a et le tampon de sortie 13. Le retard entre le signal **lN** et le signal OUT correspond au retard minimal du circuit 10, qui est de 115 picosecondes dans l'exemple de la figure 2. Quand tous les bits i-m prennent la valeur logique 1, tous les interrupteurs 12b sont passants et connectent ainsi tous les étages du réseau 12 à la sortie B de l'amplificateur 11b. Le dernier étage R-R forme avec la résistance 2R de l'avant dernier étage une résistance égale à R, de sorte qu'en remontant itérativement jusqu'au premier étage on trouve la résistance équivalente du réseau 12 égale à R. C'est la résistance minimale du réseau R qui fait débiter le plus de courant de la sortie B de l'amplificateur 11b et qui détermine le retard le plus long apporté par l'amplificateur 11b, auquel s'ajoute le retard constant de l'amplificateur 11a. Le retard maximal correspondant au pas 32 du signal de commande C vaut dans l'exemple illustré 203 picosecondes. Il apparaît de la figure 2 que la variation est proche d'une ligne droite, légèrement incurvée entre les valeurs 5 et 17 de C et une inflexion plus sensible aux valeurs 3 et 4 de C. Les pas sont aussi fins que 3 ps environ. L'avantage du réseau 12 est d'offrir une commande de retard monotone et quasi-linéaire entre une valeur minimale Tmin fixée par l'amplificateur 11a et une valeur maximale Tmax déterminée par la valeur fixe Tmin et le retard maximal que peut apporter l'amplificateur 11b et le réseau 12. D'une manière générale, si le signal de commande C est fait d'un nombre **N** de bits de commande (C = {0, ..., 2^{N-1}}), le retard est commandé linéairement par pas valant chacun (Tmax - Tmin) / 2^{N}. En d'autres termes, on a un retard progressif **T** = Tmin + (Tmax - Tmin) C / 2^{N} avec C = {0, ... 2^{N-1}}. En réalité, la légère distorsion observée dans la courbe de la figure 1 est essentiellement due au fait que la résistance équivalente du réseau 12 n'est pas toujours constante lorsque C varie entre ses deux valeurs extrêmes. D'autre part, les amplificateurs 11a et 11b étant faits en logique DCFL, ils permettent d'obtenir des retards courts et d'avoir une structure simple et très compacte, tandis que la dissymétrie des temps de commutation est corrigée par le tampon de sortie 13 en logique BDCFL. Par ailleurs, on a vu que dans le réseau 12 les étages font passer des intensités de courant respectives prédéterminées (I/2, I/4, I/8, I/16, I/32) sous la commande respective des cinq bits de commande i-m du signal de commande C. Le signal de commande C constitue ainsi une commande numérique en mode linéaire sommé. Bien sûr, d'autres commandes et d'autres structures du réseau 12 peuvent être appliquées par l'homme du métier. Notamment, les amplificateurs peuvent être tous faits en logique DCFL ou BDCFL et la finesse des pas peut être réglée par le nombre de bits du signal de commande C, un nombre de six bits permettant d'avoir 64 pas. De plus, le réseau 12 peut être adapté à un type de variation non linéaire.

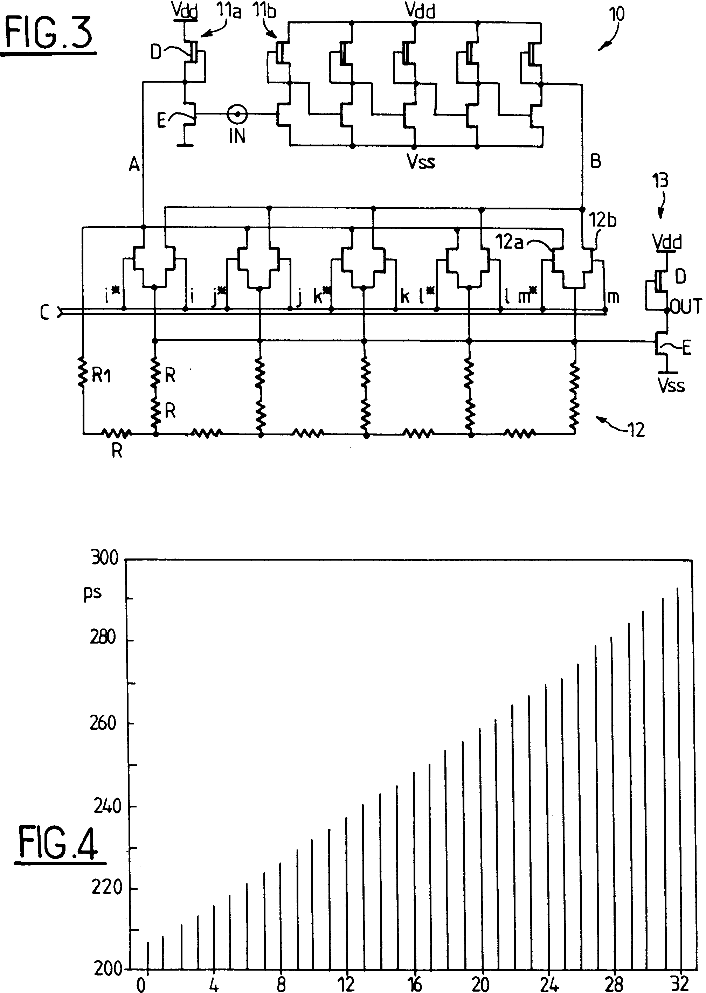

Les figures 3 et 4 illustrent un autre exemple de réalisation d'un circuit à retard 10 conforme à l'invention, faits de transistors MESFET en logique DCFL. L'amplificateur 11a est fait d'un seul inverseur DCFL et l'amplificateur 11b de cinq inverseurs en cascade. Le réseau 12 est aussi fait de cinq étages R-2R et le tampon de sortie 13 est fait d'un seul inverseur DCFL. Cependant, le réseau 12 et sa connexion aux sorties A et B des amplificateurs et du tampon de sortie 13 sont changés. Le réseau 12 comprend les cinq transistors interrupteurs 12b, ici connectés entre les branches 2R respectives des étages du réseau et la sortie B de l'amplificateur 11b. Le réseau comprend de la même façon cinq autres transistors interrupteurs 12a connectés entre les branches 2R respectives et la sortie A de l'amplificateur 11a. Le réseau est fait de cinq étages R-2R et comporte une résistance additionnelle R1 reliant la résistance R libre du premier étage R-2R à l'une des sorties A ou B, la sortie A en l'occurrence, pour les raisons indiquées ci-après. Les connexions des transistors interrupteurs 12a et 12b avec les étages R-2R respectifs sont réunies à l'entrée du tampon de sortie 13. Le signal de commande C comprend les cinq bits de commande i-m appliqués aux grilles des transistors 12b et cinq autres bits de commande i*-m* complémentaires des bits i-m et appliqués aux grilles des transistors 12a.

En fonctionnement, quand tous les bits i-m sont au niveau bas et ont la valeur logique 0 (C = 0), les interrupteurs 12b sont tous fermés et isolent ainsi l'amplificateur à retard long 11b. Les bits complémentaires i*-m* ont la valeur logique 1, de sorte que tous les interrupteurs 12a sont passants et connectent tous les étages R-2R à la sortie A de l'amplificateur à retard court 11a. Le retard minimal Tmin du circuit 10 correspond donc à cet état. Dans cet état, la résistance équivalente du réseau 12 est égale à 88R/87, soit approximativement la valeur de R. Quand au contraire tous les bits i-m ont la valeur logique 1 (C = 32), tous les interrupteurs 12a sont fermés et isolent l'amplificateur 11a tandis que tous les interrupteurs 12b sont passants et connectent tous les étages du réseau 12 à la sortie B de l'amplificateur de retard long 11b. Cet état correspond donc au retard maximal Tmax fourni par le circuit à retard 10. Entre les deux cas, par exemple lorsque le bit de poids le plus fort i commute à la valeur logique 1 et les autres restant à 0 (C = 16), seul l'interrupteur 12 b correspondant est passant tandis que seul l'interrupteur 12a correspondant est bloqué. La situation est inversée pour C = 15. Afin de garder une résistance du réseau 12 équivalente à R, on a ajouté la résistance R1 = R. Le principe du fonctionnement ressort ainsi de cette description. Le réseau conserve une résistance sensiblement égale à R, dans lequel débite donc un courant constant I issu des deux amplificateurs 11a et 11b de façon complémentaire. Ceci assure une très bonne linéarité, comme cela ressort de la figure 3. Selon cette figure, les retards varient entre environ 207 et 292 ps en 32 pas de l'ordre de 2 à 3 ps chacun.

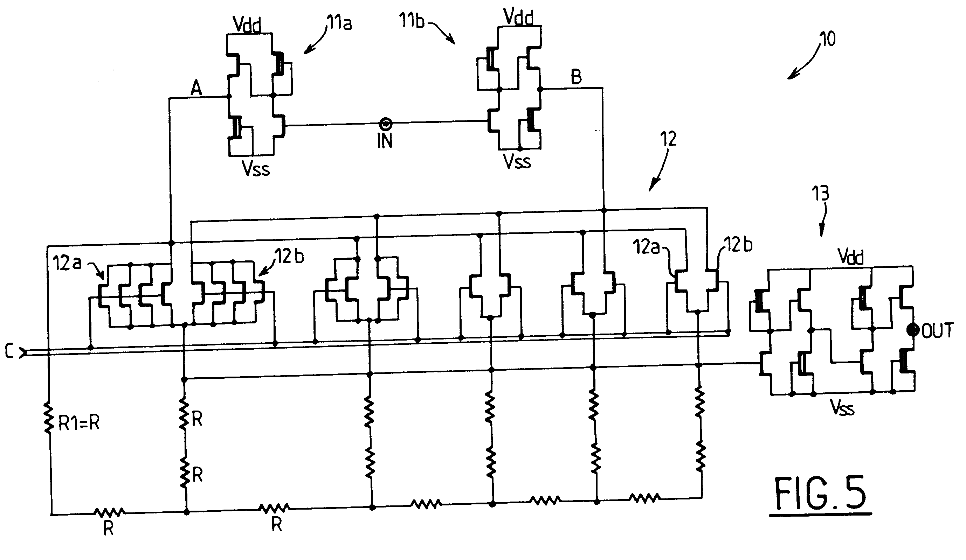

La figures 5 illustre un autre exemple de réalisation d'un circuit à retard 10 conforme à l'invention, fait de transistors MESFET en logique BDCFL. Le circuit à retard 10 illustré schématiquement dans la figure 5 est similaire à celui de la figure 3 et comprend les deux amplificateurs 11a et 11b, le réseau 12 pourvu des interrupteurs 12a et 12b recevant le signal de commande numérique C composé des dix bits de commande i-m et i*-m*, et le tampon de sortie 13. Comme différences avec le circuit de la figure 3, les amplificateurs 11 a et 11b et le tampon de sortie 13 sont faits d'inverseurs BDCFL ayant la même structure que celle du tampon de sortie 13 du circuit 10 de la figure 1. Les amplificateurs 11a et 11b illustrés sont faits chacun d'un seul inverseur mais présentent des temps de propagation différents. Dans l'exemple de réalisation illustré, les transistors de la couche d'entrée des deux inverseurs avaient les dimensions W_{D}/L_{D} = 2/1 et W_{E}/L_{E} = 10/1 mais dans la couche de sortie, W_{D}/L_{D} = 2,4/1 et W_{E}/L_{E} = 2,8 dans l'amplificateur 11a tandis que W_{D}/L_{D} = 5,6/1 et W_{E}/L_{E} = 6/1 dans l'amplificateur 11b. Les bornes de sortie A et B des amplificateurs d'entrée 11a et 11b sont reliées, d'une part, au potentiel Vss par l'intermédiaire de deux diodes respectives, dont la cathode est au potentiel Vss, de façon à bloquer la tension de sortie à environ 0,8 volt, et d'autre part aux deux bornes respectives des interrupteurs 12a et 12b. Le tampon de sortie 13 comprend deux inverseurs BDCFL en cascade. Grâce à l'emploi de la logique BDCFL, les retards sont sensiblement les mêmes pendant les temps de montée et de descente.

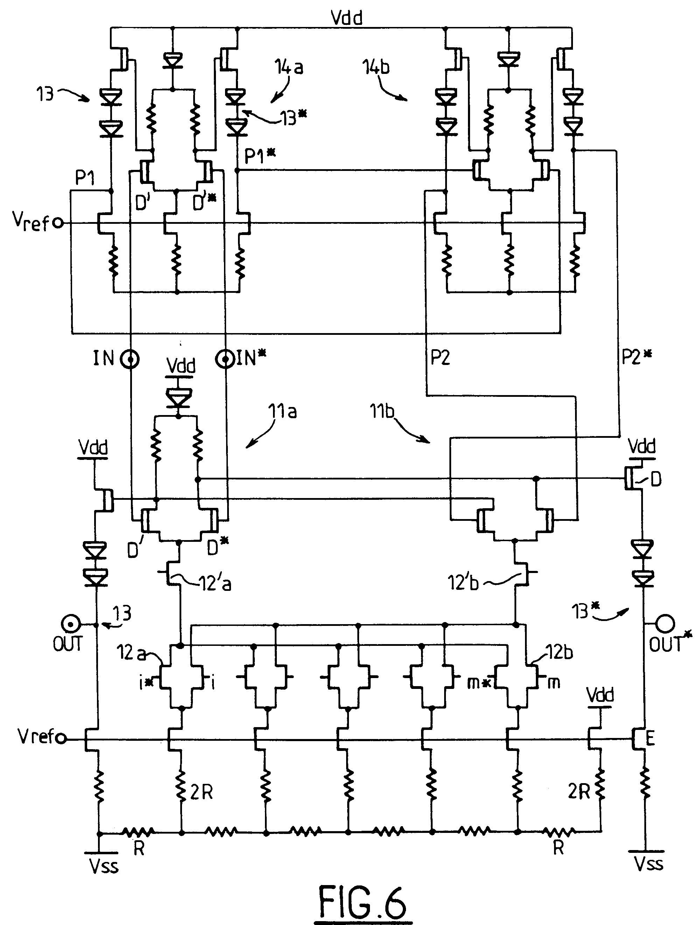

La figure 6 est relative à un quatrième exemple de réalisation conforme à l'invention. Dans la figure 6, le circuit à retard 10 est fait en logique SCFL (Source-Coupled FET Logic). La structure du circuit 10 est similaire à celle de la figure 3, mais elle correspond ici à une structure différentielle et comprend deux entrées complémentaires IN et IN*, deux amplificateurs différentiels 11a, 11b, un réseau itératif 12 à six étages R-2R et piloté par le signal de commande numérique C composé de dix bits de commande (i-m, i*-m*), et deux tampons de sorties complémentaires 13 et 13*. Il comporte en outre deux amplificateurs tampons à retard fixe 14a et 14b connectés en série et pourvus chacun de deux tampons de sortie complémentaires 13 et 13*. Dans cette logique, les amplificateurs à gain variable 11a et 11b et à retard fixe 14a et 14b sont similaires à des amplificateurs différentiels et ont une structure bien connue, faite de deux transistors à déplétion D et D* symétriques ayant leurs sources communes. Les drains des deux transistors D et D* sont connectés à deux résistances de charge respectives réunies pour être connectées au potentiel d'alimentation Vdd par l'intermédiaire d'une diode. Les tampons respectifs 13 et 13* sont formés d'un transistor à déplétion D, d'au moins une diode, d'un transistor à enrichissement E et d'une résistance connectés successivement en série entre les potentiels Vdd et Vss. Dans les amplificateurs 11a et 11b, les drains des transistors D et D* sont connectés aux grilles respectives des transistors D des tampons 13 et 13*. Les sorties complémentaires OUT et OUT* sont fournies au niveau d'une cathode d'une diode des deux tampons respectifs 13 et 13*, en l'occurrence la diode proche du drain du transistor E comme illustré. Le réseau 12 illustré comprend six sources de courant constant S formées chacune par un transistor à enrichissement E commandé par une tension de référence commune Vref et cinq paires d'interrupteurs 12a, 12b formés de transistors à enrichissement commandés par les signaux i*-m* pour les interrupteurs respectifs 12a et i-m pour les interrupteurs respectifs 12b. Les sources de chaque paire de transistors 12a et 12b sont connectées à une branche 2R respective du réseau 12 par l'intermédiaire d'un transistor source de courant S correspondant tandis que les drains sont connectés respectivement aux sources communes des amplificateurs 11a et 11b au travers de deux transistors 12'a et 12'b commandés par une tension fixe non illustrée de façon à être conducteurs et pouvant être supprimés. La branche 2R du sixième étage est connectée par un transistor source de courant S au potentiel d'alimentation Vdd pour donner au réseau 12 une résistance équivalente sensiblement constante. Le potentiel de référence Vref commun est aussi appliqué aux grilles des transistors sources de courant des amplificateurs 14a et 14b et des transistors E de tous les tampons 13 et 13*.

Le principe de fonctionnement est similaire à celui du circuit 10 de la figure 1. L'amplificateur d'entrée à gain variable 11a reçoit sur les grilles des transistors D et D* les signaux complémentaires d'entrée IN et IN*, qui sont aussi appliqués aux entrées de l'amplificateur d'entrée à gain fixe 14a. Les signaux de sortie intermédiaires P1 et P1* que fournit l'amplificateur tampon à retard fixe 14a sont appliqués sur les grilles respectives des transistors D* et D du second amplificateur tampon à retard fixe 14b. Les signaux de sortie intermédiaires P2 et P2* que fournit l'amplificateur tampon 14b sont appliqués sur les grilles des transistors respectifs D et D* du second amplificateur 11b. En supposant les transistors intermédiaires 12'a et 12'b conducteurs, les états des bits de commande i-m et i*-m* déterminent le retard entre les signaux complémentaires d'entrée IN, IN* et les signaux complémentaires de sortie OUT de la même manière que dans les circuits 10 des figures 3 et 5. Quand les bits i-m ont l'état 0 et les bits i*-m* ont l'état 1, l'amplificateur 11b est bloqué et l'amplificateur 11a est activé avec une résistance de charge minimale représentative d'un retard maximal pour cet amplificateur mais un retard minimal pour le circuit 10. Inversement, si les bits i-m ont l'état 1, l'amplificateur 11a est bloqué et l'amplificateur 11b avec les deux amplificateurs tampons 14a et 14b sont activés avec une résistance de charge minimale représentative d'un retard minimal pour l'amplificateur 11b mais maximal pour le circuit 10. Les états intermédiaires s'avèrent varier de façon très linéaire.

En conclusion, les divers exemples de réalisation illustrés mettent bien en relief que l'invention a de manière générale pour objet un circuit à retard intégré 10 comprenant deux amplificateurs 11a, 11b fournissant des retards différents et ayant une entrée commune, et des moyens de commande 12 connectés à deux bornes respectives des deux amplificateurs pour faire varier le déphasage entre les deux amplificateurs. Dans les exemple illustrés, l'amplificateur 11a est rapide et l'amplificateur 11b est lent.

Les moyens de commande peuvent être adaptés au type de commande choisi. Pour obtenir une commande numérique, les moyens de commande 12 comprennent de préférence un réseau itératif R-2R incluant des interrupteurs commandés par un signal de commande numérique C pour sélectionner les étages du réseau itératif. Les interrupteurs sont simples comme les interrupteurs 12b illustrés dans la figure 1 ou peuvent être appairés 12a, 12b et connectés auxdites bornes respectives des deux amplificateurs. Les moyens de commande peuvent aussi être adaptés au type de variation choisi. Pour obtenir une variation sensiblement linéaire avec un réseau itératif R-2R, les interrupteurs sont dimensionnés de façon à conduire dans les étages du réseau itératif un courant sensiblement égal à l/2^{N} où N représente le numéro d'ordre des étages dans le réseau. De préférence, les moyens de commande gardent une résistance équivalente sensiblement constante, sinon des moyens tels que la branche R-R1 peuvent être prévus pour donner aux moyens de commande une résistance équivalente sensiblement égale malgré la variation du signal de commande. On a vu que ce circuit est très bien adapté à une intégration dans un matériau semi-conducteur III-V avec des transistors à effet de champ en logique DCFL et/ou BDCFL, auquel cas les moyens de commande sont connectés aux bornes de sortie des deux amplificateurs. Mais on a vu aussi que les deux amplificateurs peuvent être des amplificateurs différentiels incluant les moyens de commande comme élément d'une source de courant, la sortie du circuit à retard étant constituée par une sortie commune des deux amplificateurs. Dans ce cas, il peut être intégré dans un matériau semi-conducteur III-V à transistors à effet de champ (MESFET, HEMT) en logique SCFL. Il peut aussi être intégré dans un matériau semi-conducteur monocristallin, avec des transistors à effet de champ, par exemple en CMOS, ou avec des transistors bipolaires. L'invention se rapporte à un circuit à retard tel que défini précédemment.

D'autre part, on comprend a partir de la figure 1 que l'amplificateur 11a pourrait être supprimé. Cependant, le principe de fonctionnement serait tout à fait différent de celui décrit. Le réseau 12 serait alors un moyen pour faire varier le gain de l'amplificateur 11b. Le fonctionnement serait alors conforme aux circuits à retard classiques. Ce fonctionnement pourrait aussi être obtenu du circuit à retard 10 illustré dans la figure 6, avec un seul amplificateur 11a ou 11b, ou avec les deux amplificateurs commandés en alternance par des commandes complémentaires sur les grilles des transistors 12'a et 12'b pour obtenir deux gammes de variation de retard respectives. Bien sûr, d'autres amplificateurs pourraient être ajoutés de façon bien connue pour accroître le nombre de gammes.

## Revendications

1. Circuit à retard intégré (10), caractérisé en ce qu'il comprend deux amplificateurs (11a, 11b) fournissant des retards différents et ayant une entrée commune, et des moyens de commande (12) connectés à deux bornes respectives des deux amplificateurs pour faire varier le déphasage entre les deux amplificateurs.

2. Circuit selon la revendication 1, caractérisé en ce que les moyens de commande (12) comprennent un réseau itératif R-2R incluant des interrupteurs commandés par un signal de commande numérique (C) pour sélectionner les étages du réseau itératif.

3. Circuit selon la revendication 2, caractérisé en ce que les interrupteurs sont appairés et connectés auxdites bornes respectives des deux amplificateurs.

4. Circuit selon la revendication 2 ou 3, caractérisé en ce que les interrupteurs sont dimensionnés de façon à conduire dans les étages du réseau itératif un courant sensiblement égal à I/2^{N} où N représente le numéro d'ordre des étages dans le réseau.

5. Circuit selon l'une des revendications 1 à 4, caractérisé en ce qu'il comprend des moyens (R-R1) pour donner aux moyens de commande une résistance équivalente sensiblement égale malgré la variation du signal de commande.

6. Circuit selon l'une des revendications 1 à 5, caractérisé en ce qu'il est intégré dans un matériau semi-conducteur III-V avec des transistors à effet de champ en logique DCFL et/ou BDCFL et les moyens de commande sont connectés aux bornes de sortie des deux amplificateurs.

7. Circuit selon l'une des revendications 1 à 5, caractérisé en ce que les deux amplificateurs sont des amplificateurs différentiels incluant les moyens de commande comme élément d'une source de courant, et la sortie du circuit à retard étant constituée par une sortie commune des deux amplificateurs.

8. Circuit selon la revendication 7, caractérisé en ce qu'il est intégré dans un matériau semi-conducteur III-V à transistors à effet de champ en logique SCFL.

9. Circuit selon la revendication 7, caractérisé en ce qu'il est intégré dans un matériau semi-conducteur monocristallin et comprend des transistors bipolaires.

10. Circuit intégré, caractérisé en ce qu'il comprend un circuit à retard tel que défini selon l'une des revendications 1 à 9.
